Europäisches Patentamt

European Patent Office

Office européen des brevets

(19)

(11) Veröffentlichungsnummer: **0 410 327 A2**

## (12) EUROPÄISCHE PATENTANMELDUNG

(21) Anmeldenummer: 90113987.3

(22) Anmeldetag: 20.07.90

(51) Int. Cl.5: **H03K 17/08**

(30) Priorität: 27.07.89 BG 89375/89

(43) Veröffentlichungstag der Anmeldung:
30.01.91 Patentblatt 91/05

(84) Benannte Vertragsstaaten:
**DE FR GB IT NL**

(71) Anmelder: **INSTITUTE PO ROBOTISIRANI SYSTEMI**
**Akademik G. Bonchev Strasse, Block 2**
**BG-1113 Sofia(BG)**

(72) Erfinder: **Petkov, Boryan Iliev**
**Komplex Lyulin, 215, Strasse, Block 208-E**
**1113 Sofia(BG)**
Erfinder: **Angelov, Angel Simeonov**
**Komplex Mladost 2, Block 208-A**
**1113 Sofia(BG)**
Erfinder: **Nachev, Georgi Nachev**
**Komplex Chervana Zvesda, Block 30-4**
**1113 Sofia(BG)**

(74) Vertreter: **Grupe, Peter, Dipl.-Ing. et al**
**Patentanwaltsbüro**
**Tiedtke-Bühling-Kinne-Grupe-Pellmann-Grams-Struif Bavariaring 4**
**D-8000 München 2(DE)**

(54) **Einrichtung zum Unterstützen des Abschaltens eines elektronischen Schalters mit induktiver Last.**

(57) Für die Anwendung bei dem Impulsbetrieb elektrischer Antriebe oder dergleichen wird eine Abschaltunterstützungseinrichtung angegeben, die das Abschalten eines induktiv belasteten elektronischen Schalters bei sehr niedrigen Spannungen und geringen Leistungsverlusten und somit verbessertem Nutzwirkungsgrad sicherstellt und auch in Gegentaktschaltungen anwendbar ist. Der elektronische Schalter 3 und die induktive Last 2 sind in Reihenschaltung an eine Gleichstromquelle 1 angeschlossen. An den Verbindungspunkt zwischen der induktiven Last 2 und dem elektronischen Schalter 3 ist die Kathode einer langsamen Diode 4 angeschlossen, deren Anode mit der Kathode einer Zenerdiode 5 und mit einem Ende eines Widerstands 6 verbunden ist. Die Anode der Zenerdiode 5 und das andere Ende des Widerstands 6 sind jeweils an einen der Pole der Gleichstromquelle 1 angeschlossen.

Fig. 1.

EP 0 410 327 A2

# EINRICHTUNG ZUM UNTERSTÜTZEN DES ABSCHALTENS EINES ELEKTRONISCHEN SCHALTERS MIT INDUKTIVER LAST

Die Erfindung bezieht sich auf eine Abschaltunterstützungseinrichtung für einen induktiv belasteten elektronischen Schalter, der bei Impulsbetrieb von elektrischen Antrieben oder dergleichen Anwendung findet.

Es ist bereits beispielsweise aus der Veröffentlichung "Switching mode power supply" von MBLE, Seiten 57 und 58, oder "Power transistors in its environments" von Thomson CSF, Seiten 184 und 193 eine Einrichtung zum Unterstützen des Abschaltens eines elektronischen Schalters mit einer induktiven Last bekannt, die in Reihe mit dem Schalter an die Pole einer Gleichstromquelle angeschlossen ist, wobei der Schalter mit dem negativen Pol verbunden ist. An den Verbindungspunkt zwischen der Last und dem Schalter sind die Anode einer schnellen Diode und ein Ende eines Widerstands angeschlossen, dessen anderes Ende mit der Kathode der Diode und mit einem Anschluß eines Kondensators verbunden ist, dessen anderer Anschluß mit dem negativen Pol der Gleichstromquelle verbunden ist (RCD-Glied).

Bei dieser bekannten Einrichtung entstehen jedoch bei dem Abschalten des elektronischen Schalters ziemlich hohe Spannungen sowie Leistungsverluste an dem Schalter und an dem Widerstand durch Wärmeerzeugung, wodurch der Nutzwirkungsgrad verringert ist. Da ein Kondensator verwendet wird, ist das Anwenden der bekannten Einrichtung in Gegentaktschaltungen wegen der ungünstigen Wechselwirkung zwischen den Stufen sehr erschwert und ein Integrieren im Halbleitermaterial des elektronischen Schalters unmöglich.

Der Erfindung liegt die Aufgabe zugrunde, zum Unterstützen des Abschaltens eines elektronischen Schalters mit induktiver Last eine Einrichtung zu schaffen, mit der das Abschalten bei niedriger Spannung mit geringen Leistungsverlusten und damit höherem Nutzwirkungsgrad erfolgt und mit der die Anwendung in Gegentaktschaltungen und das Integrieren im Halbleitermaterial des elektronischen Schalters ermöglicht ist.

Diese Aufgabe wird erfindungsgemäß mit einer Einrichtung zum Unterstützen des Abschaltens eines elektronischen Schalters mit induktiver Last gelöst, wobei die Einrichtung einen Widerstand aufweist und die induktive Last in Reihenschaltung mit dem elektronischen Schalter an eine Gleichstromquelle angeschlossen ist, deren negativer Pol mit dem Schalter verbunden ist. Erfindungsgemäß ist an dem Verbindungspunkt zwischen der induktiven Last und dem elektronischen Schalter die Kathode einer langsamen Diode angeschlossen, deren Anode mit der Kathode einer Zenerdiode und ren Anode mit der Kathode einer Zenerdiode und mit einem Ende des Widerstands verbunden ist. Die Anode der Zenerdiode ist mit dem negativen Pol der Gleichstromquelle verbunden, während das andere Ende des Widerstands mit dem positiven Pol der Gleichstromquelle verbunden ist.

Die erfindungsgemäße Einrichtung ergibt den Vorteil, daß das Abschalten des elektronischen Schalters bei sehr niedrigen Spannungen und geringen Leistungsverlusten sichergestellt ist, also im sicheren Arbeitsbereich, für den der elektronische Schalter ausgelegt ist, und nach einer Abschaltkurve, die einer idealen Kurve nahekommt und die bei dem Abschaltvorgang praktisch ein völliges Trennen von Strom und Leistung ergibt. Dies führt zu einer Verbesserung des Gesamtwirkungsgrads. Da kein Kondensator ver wendet wird, kann die Einrichtung in Gegentaktschaltungen verwendet werden und im Halbleitermaterial des elektronischen Schalters integriert werden. Weitere Vorteile der erfindungsgemäßen Einrichtung bestehen darin, das einfache herkömmliche Komponenten mit kleinen Abmessungen verwendet werden und die Komponenten in Schaltungen mit mehr als einem elektronischen Schalter mit einem gemeinsamen Schaltungspunkt wie beispielsweise in Brückenschaltungen eingesetzt werden können.

Die Erfindung wird nachstehend anhand von Ausführungsbeispielen unter Bezugnahme auf die Zeichnung näher erläutert, in welcher

Fig. 1 ein Schaltbild der Abschaltunterstützungseinrichtung gemäß einem Ausführungsbeispiel ist,

Fig. 2 Zeitdiagramme von Strom, Spannung und Verlustleistung an einem elektronischen Schalter zeigt und

Fig. 3 ein Schaltbild der Einrichtung gemäß einem Ausführungsbeispiel bei der Verwendung für den dreiphasigen Antrieb eines bürstenlosen Gleichstrommotors ist.

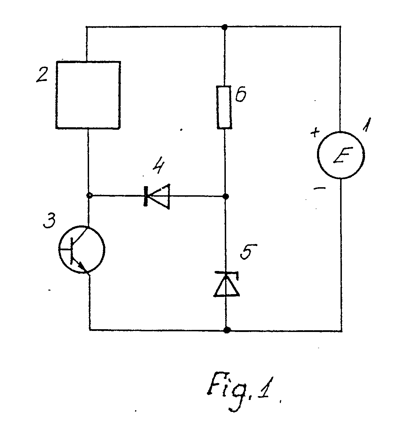

Die Fig. 1 zeigt ein Ausführungsbeispiel für die Einrichtung zum Unterstützen des Abschaltens eines induktiv belasteten elektronischen Schalters. Gemäß Fig. 1 sind an eine Gleichstromquelle 1 in Reihenschaltung eine induktive Last 2 und ein elektronischer Schalter 3 angeschlossen, welcher mit dem negativen Pol der Gleichstromquelle verbunden ist. An del Schaltungspunkt zwischen der induktiven Last 2 und dem elektronischen Schalter 3 ist die Kathode einer langsamen Diode 4 angeschlossen, deren Anode mit der Kathode einer Zenerdiode 5 und mit einem Ende eines Widerstands 6 verbunden ist. Die Anode der Zenerdiode 5 ist mit dem negativen Pol der Gleichstromquelle 1 verbunden, während das andere Ende des Widerstands 6 mit dem positiven Pol der Gleichstromquelle 1 verbunden ist.

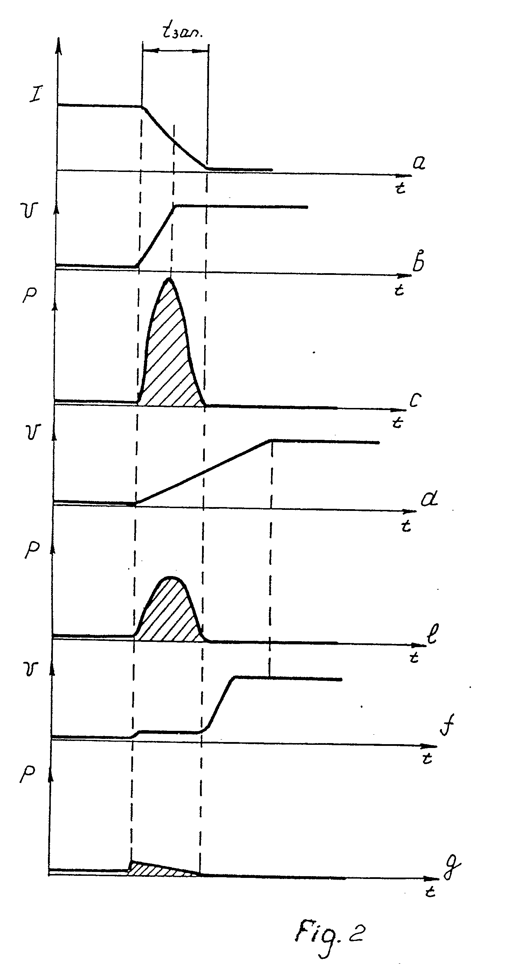

Die Zeitdiagramme in Fig. 2 veranschaulichen das Abschalten des elektronischen Schalters, wobei die Fig. 2a den Strom über den Schalter zeigt, die Fig. 2b und 2c die Spannung bzw. die Verlustleistung an dem Schalter ohne eine Abschaltunterstützungeinrichtung zeigen, die Fig. 2d und 2e die Spannung bzw. die Verlustleistung an dem Schalter bei Verwendung der bekannten Abschaltunterstützungseinrichtung zeigen und die Fig. 2f und 2g die Spannung bzw. die Verlustleistung an dem Schalter bei der Verwendung der erfindungsgemäßen Abschaltunterstützungseinrichtung zeigen.

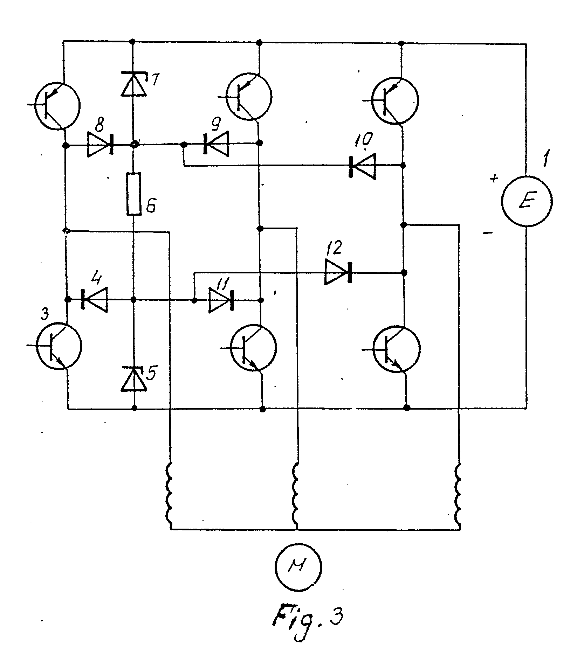

Als Variante ist in Fig. 3 ein Ausführungsbeispiel der Abschaltunterstützungseinrichtung für den dreiphasigen Antrieb eines bürstenlosen Gleichstrommotors gezeigt. Gemäß Fig. 3 ist der Widerstand 6 für alle sechs elektronischen Schalter gemeinsam vorgesehen, während die Zenerdiode 5 und eine Zenerdiode 7 jeweils gemeinsam oberen bzw. unteren Schaltern zugeordnet sind. An die elektronischen Schalter sind jeweils einzeln die langsame Diode 4 und langsame Dioden 8, 9, 10, 11 und 12 angeschlossen.

Die Funktionsweise der erfindungsgemäßen Abschaltunterstützungseinrichtung ist folgende: Bei dem Abschalten des elektronischen Schalters 3 beginnt der darüber fließende Strom abzufallen und die Spannung anzusteigen, die einen Gegenstrom über die langsame Diode 4 hervorrufen würde, welche über den Widerstand und die Zenerdiode 5 in Durchlaßrichtung vorgespannt ist. Durch diese Vorspannung wird das weitere Ansteigen der Spannung bis zu dem Zeitpunkt verhindert, an dem sich wieder der Sperrwiderstand der langsamen bzw. trägen Diode 4 einstellt. Damit läuft der Abschaltvorgang bei einer Spannung ab, die im Vergleich zu der Spannung am abgeschalteten elektronischen Schalter sehr niedrig ist und praktisch konstant ist. Bis zum völligen Sperren des über den elektronischen Schalter 3 fließenden Stroms wird der Laststrom dynamisch zwischen dem Schalter 3 und der Reihenschaltung aus der langsamen Diode 4 und der Zenerdiode 5 aufgeteilt. Nach dem Ablauf der Zeit für das Wiederherstellen des Gegenstromwiderstands der langsamen Diode 4 sperrt diese Diode, wodurch das Abschalten hinsichtlich der induktiven Last 2 beendet ist. Beim nächsten Einschalten des elektronischen Schalters 3 wird die langsame Diode 4 wieder in der Durchlaßrichtung vorgespannt, wonach sich der vorstehend beschriebene Zyklus wiederholt.

Für die Anwendung bei dem Impulsbetrieb elektrischer Antriebe oder dergleichen wird eine Abschaltunterstützungseinrichtung angegeben, die das Abschalten eines induktiv belasteten elektronischen Schalters bei sehr niedrigen Spannungen und geringen Leistungsverlusten und somit verbessertem Nutzwirkungsgrad sicherstellt und auch in Gegentaktschaltungen anwendbar ist. Der elektronische Schalter 3 und die induktive Last 2 sind in Reihenschaltung an eine Gleichstromquelle 1 angeschlossen. An den Verbindungspunkt zwischen der induktiven Last 2 und dem elektronischen Schalter 3 ist die Kathode einer langsamen Diode 4 angeschlossen, deren Anode mit der Kathode einer Zenerdiode 5 und mit einem Ende eines Widerstands 6 verbunden ist. Die Anode der Zenerdiode 5 und das andere Ende des Widerstands 6 sind jeweils an einen der Pole der Gleichstromquelle 1 angeschlossen.

**Ansprüche**

1. Einrichtung zum Unterstützen des Abschaltens eines induktiv belasteten elektronischen Schalters, die einen Widerstand aufweist, wobei die induktive Last und der elektronische Schalter in Reihenschaltung an eine Gleichstromquelle angeschlossen sind, deren negativer Pol mit dem elektronischen Schalter verbunden ist, dadurch gekennzeichnet, daß an dem Verbindungspunkt zwischen der induktiven Last (2) und dem elektronischen Schalter (3) die Kathode einer langsamen Diode (4) angeschlossen ist, deren Anode mit der Kathode einer Zenerdiode (5) und mit einem Ende des Widerstands (6) verbunden ist, wobei die Anode der Zenerdiode an den negativen Pol der Gleichstromquelle (1) angeschlossen ist und das andere Ende des Widerstands an den positiven Pol der Gleichstromquelle angeschlossen ist.

Fig. 1

Fig. 2

Fig. 3